## Europäisches Patentamt
## European Patent Office
## Office européen des brevets

(11) Veröffentlichungsnummer: **0 361 151**
**A2**

(12) **EUROPÄISCHE PATENTANMELDUNG**

(21) Anmeldenummer: **89116454.3**

(22) Anmeldetag: **06.09.89**

(51) Int. Cl.5: **H04B 10/12 , H04L 27/12**

(30) Priorität: **30.09.88 DE 3833273**

(43) Veröffentlichungstag der Anmeldung:
**04.04.90 Patentblatt 90/14**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Auracher, Franz, Dr.**
**Eichenstrasse 26**
**D-8021 Baierbrunn(DE)**
Erfinder: **Ebberg, Alfred, Dipl.-Ing.**
**Niemöllerallee 18**
**D-8000 München 83(DE)**
Erfinder: **Noll, Bernd, Dipl.-Ing.**
**Zillertalstrasse 69**
**D-8000 München 70(DE)**
Erfinder: **Meissner, Eckhard, Dipl.-Ing.**
**Böglstrasse 2/2**
**D-8000 München 83(DE)**
Erfinder: **Rodler, Hermann, Dipl.-Ing.**
**Waldperlacher Strasse 67a**
**D-8000 München 83(DE)**

(54) **Vorrichtung zum Erzeugen eines zwei voneinander verschiedene Polarisationszustände aufweisenden FSK-modulierten optischen Signals für ein optisches Übertragungssystem mit einem optischen Zweifilter-FSK-Überlagerungsempfänger.**

(57) 2.1 Bei einem optischen Übertragungssystem mit Zweifilter-FSK-Überlagerungsempfänger ist polarisationsunabhängiger Empfang möglich, wenn das dem Empfänger zugeführte optische Signal in bestimmter Weise zwei zueinander orthogonale Polarisationszustände aufweist. Eine bekannte Vorrichtung zum Erzeugen eines solchen Signals weist eine Einrichtung zum Umwandeln eines polarisierten FSK-modulierten optischen Sendesignals in das gewünschte optische Signal auf. Bei dieser Einrichtung muß der Frequenzhub $\Delta f$ sehr groß gegenüber der Datenrate gewählt werden. Bei der Erfindung kann dagegen der Frequenzhub frei gewählt werden kann.

2.2 Dazu besteht die Einrichtung zum Umwandeln des polarisierten optischen Sendesignals ($S_1(t)$) in das die zueinander orthogonalen Polarisationszustände aufweisende optische Signal ($S_2(t)$) aus einem von einem digitalen Datensignal d(t) gesteuerten Polarisationsumschalter.

2.3 Anwendung für optische Übertragungssysteme mit Überlagerungsempfang

# Vorrichtung zum Erzeugen eines zwei voneinander verschiedene Polarisationszustände aufweisenden FSK-modulierten optischen Signals für ein optisches Übertragungssystem mit einem optischen Zweifilter-FSK-Überlagerungsempfänger

Die Erfindung betrifft eine Vorrichtung zum Erzeugen eines zwei voneinander verschiedene Polarisationszustände aufweisenden FSK-modulierten optischen Signals für ein optisches Überlagerungssystem mit einem optischen Zweifilter-FSK-Überlagerungsempfänger nach dem Oberbegriff des Patentanspruchs.

In üblichen optischen Empfängern mit Überlagerungsempfang, beispielsweise optischen Heterodynempfängern, schwankt die Amplitude des Zwischenfrequenzsignals mit der relativen Lage der Polarisationszustände des optischen Datensignals und des optischen Signals eines Lokaloszillators. Es müssen daher Vorkehrungen getroffen werden, um diese Schwankungen möglichst gering zu halten. Die bekanntesten Abhilfen sind die Polarisationsnachführung mittels einer Regelschleife (Electron. Lett. 22 (1986) S. 1341-1343), der Polarisationsquadraturempfang (Electron. Lett. 22 (1987) S. 168-169) oder das Polarisations-Scrambling (Electron. Lett 23 (1987) S. 513-514).

Empfänger mit Polarisationsnachführung erreichen zwar theoretisch die höchste Empfindlichkeit, der Aufwand für die Regelung ist jedoch beträchtlich.

Polarisationsquadraturempfänger stellen eine zuverlässige Alternative dar, erfordern jedoch eine Zerlegung optischer Signale in zwei zueinander orthogonal polarisierte Teilsignale und zwei Empfänger für diese Teilsignale.

Bei beiden Methoden ist ein erhöhter Aufwand im Empfänger erforderlich, was bei Anwendungen im Teilnehmerbereich besonders problematisch ist.

Beim Polarisations-Scrambling kann dagegen der erhöhte Aufwand auf die Senderseite verschoben werden. Bei diesem Verfahren wird der Polarisationszustand des Datensignals im allgemeinen mehrmals während der Bitdauer umgetastet, so daß das Zwischenfrequenzsignal einen Mittelwert über unterschiedliche Polarisationszustände darstellt. Theoretisch beträgt der Empfindlichkeitsverlust bei diesem Verfahren gegenüber der idealen Polarisationsnachführung mindestens 3 dB. Für höhere Datenraten besteht das Problem, daß sehr schnelle Polarisationsschalter erforderlich sind und die erforderliche Empfängerbandbreite merklich erhöht wird.

Eine weitere Möglichkeit für einen polarisationsunempfindlichen Empfang ist eine Vorrichtung der eingangs genannten Art, das beispielsweise aus Electron. Lett. 24 (1988) S. 358-360 bekannt ist. Bei dieser bekannten Vorrichtung sind die voneinander verschiedenen Polarisationszustände des FSK-modulierten optischen Signals zueinander orthogonale Polarisationszustände. Da derartige Polarisationszustände über relativ lange optische Übertragungsstrecken, beispielsweise Lichtwellenleiter-Strecken, weitgehend erhalten bleiben, ist polarisationsunempfindlicher Empfang möglich. Zur Erzeugung des die beiden voneinander verschiedenen Polarisationszustände aufweisenden FSK-modulierten optischen Signals wird bei dem bekannten Verfahren der eingangs genannten Art das FSK-modulierte polarisierte optische Sendesignal durch ein stark doppelbrechendes Medium geschickt, nach dessen Durchlaufen die den Bitzuständen 0 bzw. 1 des digitalen Datensignals entsprechenden beiden optischen Frequenzen des FSK-modulierten optischen Sendesignals zueinander orthogonal polarisiert sind. Diese Bedingung ist nur für einen Wert der Differenz zwischen diesen beiden Frequenzen streng erfüllt. Aus diesem Grund muß der Frequenzhub $\Delta f$ sehr groß gegenüber der Datenrate gewählt werden, daß die Abweichung von der Orthogonalität innerhalb der Signalbandbreite gering ist. Bei dem bekannten Verfahren ist beispielsweise für eine Datenrate von nur 50 Mbit s ein Frequenzhub von $\Delta f = 1$ GHz gewählt. Eine Vorrichtung der eingangs genannten Art ist nur für ein optisches Übertragungssystem mit einem optischen Zweifilter-FSK-Überlagerungs empfänger geeignet.

Aufgabe der Erfindung ist es, eine Vorrichtung der eingangs genannten Art dahingehend zu verbessern, daß der Frequenzhub f frei gewählt und dadurch der Empfänger bezüglich der Bandbreite und somit der Empfindlichgkeit optimierbar ist.

Diese Aufgabe wird durch die im kennzeichnenden Teil des Patentanspruchs angegebenen Merkmale gelöst.

Die Erfindung wird anhand der Figur in der nachfolgenden Beschreibung beispielhaft näher erläutert.

Die Figur zeigt in schematischer Darstellung ein Ausführungsbeispiel einer erfindungsgemäßen Vorrichtung in einem optischen Übertragungssystem mit Zweifilter -FSK-Heterodynempfänger.

Das in der Figur dargestellte optische Übertragungssystem besteht in herkömmlicher Weise aus einem Taktgenerator 1 zur Erzeugung eines das optische FSK-modulierte Sendesignal taktenden Taktes in Form elektrischer Taktimpulse $I_T$, einer von dem Takt getakteten Modulationseinrichtung 2, in welcher ein dieser Einrichtung 2 zugeführtes digitales elektrisches Datensignal d(t) mit dem Takt getaktet und moduliert und an einem Ausgang A der Modulationseinrichtung 2 als ein elektrisches, mit dem bestimmten Takt getaktetes FSK-moduliertes Signal ausgegeben wird, aus einem elektrooptischen Wandler, beispielsweise einer Laserdiode, die das am Ausgang A ausgegebene FSK-modulierte elektrische Signal in ein entsprechendes, mit dem Takt getaktetes polarisiertes, FSK-moduliertes optisches Sendesignal $S_1(t)$ umwandelt, aus einer Einrichtung 4 zum Umwandeln des polarisierten, FSK-modulierten Sendesignals $S_1(t)$ in ein entsprechend FSK-moduliertes optisches Signal $S_2(t)$, das zwei zueinander orthogonale Polarisationszustände aufweist, aus einer optischen Übertragungsstrecke 5, beispielsweise eine optische Faser, die das Signal $S_2(t)$ zu einer optischen Signalüberlagerungseinrichtung 6 auf der Empfängerseite des Übertragungssystems trägt, in welcher das Signal $S_2(t)$ mit einem optischen Signal eines Lokaloszillators 8 überlagert wird, und aus einem optischen Zweifilter-FSK-Heterodynempfänger 7, dem die überlagerten optischen Signale in bekannter Weise zugeführt sind, und der an einem Ausgang 701 ein elektrisches Signal ausgibt, das dem digitalen elektrischen Datensignal $d(t)$ entspricht.

Das polarisierte FSK-modulierte optische Sendesignal $S_1(t)$ kann mathematisch generell dargestellt werden durch

$$S_1(t) = A_0 \cos [2 \pi (f_0 + \Delta f . d(t)) + \phi]$$

wobei $A_0$ eine Signalamplitude, $f_0$ eine vom elektrooptischen Wandler abgegebene Grundlichtfrequenz, $\Delta f$ den Frequenzhub, $d(t)$ das digitale elektrische Datensignal und $\phi$ eine Phase bedeuten. Das digitale elektrische Datensignal $d(t)$ kann zwei Bitzustände, beispielsweise 0 und 1 annehmen. In diesem Fall sendet der elektrooptische Wandler für den Bitzustand 0 die Grundlichtfrequenz $f_0$ und für den Bitzustand 1 die Lichtfrequenz $f_1 = F_0 + \Delta f$ aus.

Die optische Überlagerungseinrichtung 6 kann beispielsweise aus einem optischen Richtkoppler bestehen.

Der bekannte optische Zweifilter-FSK-Heterodynempfänger 7 weist zwei Empfängerdioden 71 und 72, einen nachgeschalteten Verstärker 73, ein Bandpaßfilter 74 zum Ausfiltern der oberen Zwischenfrequenz $f_0 = f_{2F} + \Delta f/2$, ein Bandpaßfilter 75 zum Ausfiltern der unteren Zwischenfrequenz $f_u = f_{2F} - \Delta f.2$, einen dem Bandpaßfilter 74 zugeordneten Gleichrichter 76 und einen dem Bandpaßfilter 75 zugeordneten Gleichrichter 77, eine Subtrahiereinrichtung 78 zum Subtrahieren von Signalen aus den Gleichrichtern 76 und 77, einen dem Substrahierer nachgeschalteten Verstärker 79 und ein Tiefpaßfilter 70 mit dem Ausgang 701 auf.

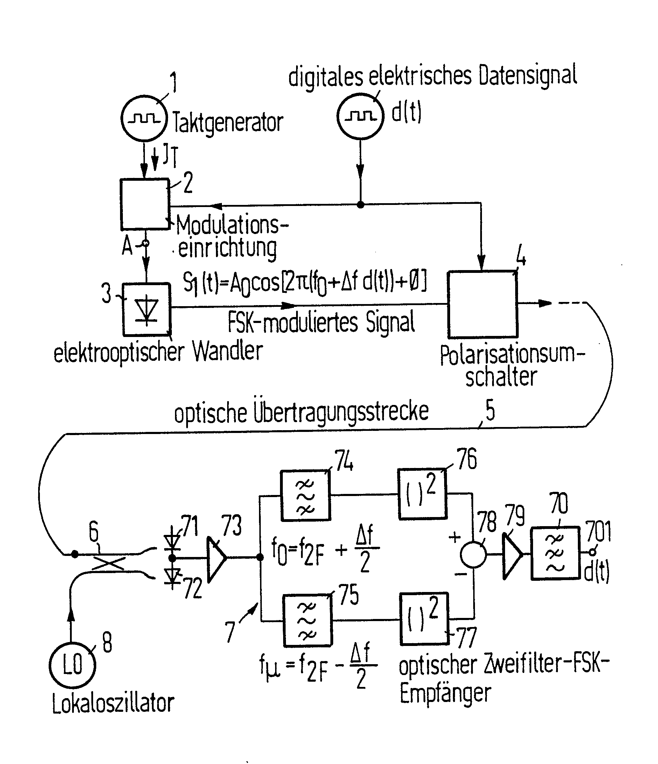

Neu bei dem Übertragungssystem nach Figur 1 ist, daß die Einrichtung 4 zum Umschalten des Polarisationszustandes aus einem vom digitalen elektrischen Datensignal $d(t)$ gesteuerten Polarisationsumschalter besteht, dem das polarisierte FSK-

modulierte optische Sendesignal $S_1(t)$ zugeführt ist. Dieser Polarisationsumschalter erzeugt das die beiden zueinander orthogonalen Polarisationszustände aufweisende, FSK-modulierte optische Signal $S_2(t)$ durch Umtasten des Polarisationszustandes des Sendesignals $S_1(t)$ entsprechend den beiden Bitzuständen des digitalen Datensignals $d(t)$ derart, daß die einem Bitzustand des digitalen elektrischen Datensignals $d(t)$ zugeordnete Frequenz des optischen Sendesignals $S_1(t)$ in einem Polaristionszustand und die dem anderen Bitzustand des Datensignals $d(t)$ zugeordnete Frequenz in dem zum einen Polarisationszustand orthogonalen Polarisationszustand zum Empfänger 7 übertragen wird. Danach wird z.B. die Grundfrequenz $f_0$ in einem Polarisationszustand und die andere Frequenz $f_1$ im anderen Polarisationszustand übertragen.

Polarisationsumschalter, wie sie bei der erfindungsgemäßen Vorrichtung benötigt werden, können z.B. auf einfache Weise mittels Phasenmodulatoren realisiert werden, wenn diese für orthogonale Polarisationszustände einen unterschiedlichen Phasenhub aufweisen. Z.B. können $LiNbO_3$-Phasenmodulatoren in Wellenleiterausführung zur Anwendung kommen. Das linear polarisierte optische Sendesignal $S_1(t)$ wird unter $45°$ zur optischen Hauptachse des Kristalls eingekoppelt und die Amplitude der Steuerspannung so eingestellt, daß der Unterschied im Phasenhub zwischen TE-polarisiertem Licht und TM-polarisiertem Licht $180°$ beträgt. Am Ausgang des Phasenmodulators treten dann zueinander orthogonale Polarisationszustände auf.

## Ansprüche

Vorrichtung zum Erzeugen eines zwei voneinander verschiedene Polarisationszustände aufweisenden FSK-modulierten optischen Signals ($S_2(t)$) aus einem entsprechend einem digitalen elektrischen Datensignal ($d(t)$) FSK-modulierten, polarisierten optischen Sendesignal ($S_1(t)$) für ein optisches Übertragungssystem mit einem optischen Zweifilter-FSK-Überlagerungsempfänger (7), zu dem das die verschiedenen Polarisationszustände aufweisende optische Signal ($S_2(t)$) übertragbar ist, wobei eine Einrichtung (4) zum Umwandeln des polarisierten optischen Sendesignals ($S_1(t)$) in das verschiedene Polarisationszustände aufweisende optische Signal ($S_2(t)$) vorgesehen ist, **dadurch gekennzeichnet,** daß die Einrichtung (4) zum Umwandeln des optischen Sendesignals ($S_1(t)$) in das die verschiedenen Polarisationszustände aufweisende optische Signal ($S_2(t)$) aus einem vom digitalen Datensignal ($d(t)$) gesteuerten Polarisationsumschalter besteht.

digitales elektrisches Datensignal d(t)

$1$ Taktgenerator

$T$

$2$ Modulations-einrichtung

$A$

$3$ elektrooptischer Wandler

$S_1(t) = A_0 \cos[2\pi(f_0 + \Delta f \, d(t)) + \varnothing]$

FSK-moduliertes Signal

$4$ Polarisationsum-schalter

optische Übertragungsstrecke $5$

$6$

$71$ $72$ $73$

$74$ $f_0 = f_{2F} + \dfrac{\Delta f}{2}$

$75$ $f_\mu = f_{2F} - \dfrac{\Delta f}{2}$

$76$ $(\,)^2$

$77$ $(\,)^2$

$78$ $+$ $-$

$79$ $70$ $701$ d(t)

$7$

LO $8$ Lokaloszillator

optischer Zweifilter-FSK-Empfänger